# EUROPEAN PATENT APPLICATION

(11) **EP 2 453 491 A1**
(43) Date of publication of application: **16.05.2012**
(21) Application number: 10797022.0
(22) Date of filing: 23.06.2010
(51) Int. Cl.: H01L 33/62, H01L 33/60

(54) **LEAD FRAME FOR OPTICAL SEMICONDUCTOR DEVICE, MANUFACTURING METHOD OF LEAD FRAME FOR OPTICAL SEMICONDUCTOR DEVICE, AND OPTICAL SEMICONDUCTOR DEVICE**

(30) Priority: 10.07.2009 JP 2009164132; 09.06.2010 JP 2010131605
(71) Applicant: Furukawa Electric Co., Ltd., Chiyoda-ku Tokyo 100-8322 (JP)
(72) Inventor: KOBAYASHI, Yoshiaki, Tokyo 100-8322 (JP); KOSEKI, Kazuhiro, Tokyo 100-8322 (JP); KIKUCHI, Shin, Tokyo 100-8322 (JP)
(74) Representative: Lieck, Hans-Peter
(86) International application number: PCT/JP2010/060672
(87) International publication number: WO 2011/004711

(57) **Abstract**

A lead frame for an optical semiconductor device, having: a layer 2 composed of silver or a silver alloy formed on an electrically-conductive substrate 1; a metal oxide layer 3 of a metal other than silver as an outer layer of the layer composed of silver or a silver alloy, wherein the metal oxide layer 3 is colorless and transparent or silver gray in color, and has a thickness thereof from 0.001 to 0.2 µm; a method of producing the same; and an optical semiconductor device utilizing the same.

## Description

### TECHNICAL FIELD

The present invention relates to a lead frame for an optical semiconductor device, a method of producing the same, and an optical semiconductor device.

### BACKGROUND ART

Lead frames for optical semiconductor devices have been widely used in constitution parts of light sources for various display and lighting, in which optical semiconductor elements (light-emitting elements), such as LEDs (light-emitting diodes), are utilized as the light sources. Such an optical semiconductor device is produced by, for example, arranging a lead frame as a substrate, mounting a light-emitting element on the lead frame, and sealing the light-emitting element and its surrounding with a resin, to prevent deterioration of the light-emitting element and its surrounded region by external factors, such as heat, humidity, and oxidization.

When a LED element is used as a light source for lighting, there is a demand for reflective materials for lead frames to have a high reflectance (e.g. a reflectance of 80% or more) in the whole regions of visible light wavelength (400 to 800 nm). Recent LED elements are assumed to be utilized for a long time period, such as tens of thousands of hours, and thus the study of the long operation life of those has been conducted. Further, there is a further demand that the reflectance is not reduced even if lighting is performed for a long time period. Thus, in optical semiconductor devices to be used as light sources for lighting, the reflection property of reflective materials and the long-term stability of the reflectance are very important factors upon which product performances depend.

Responding to such a demand, for the purpose of improvement in the light reflectance (hereinafter referred to as reflectance) in many cases, a layer (coating) composed of silver or a silver alloy is formed on the lead frame arranged in the portion beneath a LED element. The silver coating is known for its high reflectance in a visible light region. Specifically, conventionally known techniques include: forming a silver-plating layer on a reflection plane (Patent Literature 1); and forming a silver or silver alloy layer, followed by subjecting the layer to a heat treatment at 200°C or higher for 30 sec or longer, to give a grain diameter in the resultant layer of 0.5 µm to 30 µm (Patent Literature 2).

However, as in the technique described in Patent Literature 1, when a layer composed of silver or a silver alloy was simply formed on a lead frame, a sulfurization reaction of the silver surface occurred, due to a sulfur component remaining in a sealing resin, to blacken, resulting in a decrease in the reflectance, which was a problem. Further, the adhesion property between silver and a resin is relatively poor. As a result, a gap occurred between the sealing resin and the silver plane, and a moisture and salt content permeated into the silver plane from the gap, resulting in migration, which was also a problem.

As in the technique described in Patent Literature 2, when the heat treatment was performed at a temperature 200°C or higher, silver or a silver alloy was oxidized by the affection of the remaining oxygen, and the reflectance was decreased as compared with the case where such a means was not performed, which was another problem. This is because a dark-brown silver oxide was formed on the surface layer, by oxidization of the silver or silver alloy, thereby causing a decrease in the reflectance.

The inventors of the present invention found that, when the lead frames described in Patent Literatures 1 and 2 were used for optical semiconductor devices using LED elements and a silicone resin was used as a sealing resin, the luminance was decreased with the lapse of time. This is considered because the silicone resin has characteristics of a high gas-permeation property, and thus silver was sulfurized and blackened by heat in emitting a light from the LED element, when a sulfur component and oxygen in the air passed through the silicone resin of the sealing resin and reached the surface of the silver or silver alloy. Moreover, silver has a photocatalytic effect, and thus the organic substance component reached the surface layer was decomposed by, particularly blue light of the LED element, and a black carbon was formed on the surface. As a result, we found a problem that the circumference of the LED was blackened and the reflectance was decreased.

In order to solve the problems, a method of improving the stability of the lead frame is contemplated by comprising a coating with any of various kinds of noble metals other than silver, without the layer composed of silver or a silver alloy. For example, a method was proposed, for forming a palladium layer in a thickness of 0.005 to 0.15 µm on a nickel underlying layer, and forming a rhodium layer in a thickness of 0.003 to 0.05 µm as an outermost layer, to improve the reflectance (Patent Literature 3).

### CITATION LIST

### PATENT LITERATURES

Patent Literature 1: JP-A-61-148883 ("JP-A" means unexamined published Japanese patent application)
Patent Literature 2: JP-A-2008-016674
Patent Literature 3: JP-A-2005-129970

### SUMMARY OF INVENTION

### TECHNICAL PROBLEM

However, a lead frame formed by the technique described in Patent Literature 3 was poor in the reflectance as compared to a lead frame with the layer composed of silver or a silver alloy, and difficult to achieve a level of 80% or more of reflectance which is required in the whole regions of the visible light region (400 to 800 nm) as a light source for lighting. Particularly in the rhodium layer, because of the presence of a wavelength region whose reflectance is lower by 20% or more than that of a silver layer, required characteristics of the reflectance in blue-color or white-color optical semiconductor devices were not satisfied.

Thus, the present invention is contemplated for providing a lead frame for an optical semiconductor device, which is good in the reflection property in the whole visible light region (400 to 800 nm), and good in the adhesion property to the sealing resin, and does not cause any decrease of luminance for a long period of time; a method of producing the same; and an optical semiconductor device using the same.

### SOLUTION TO PROBLEM

In view of the above-described problems, the inventors of the present invention, having been studied keenly, have found that an excellent lead frame for a semiconductor device can be obtained, which lead frame is good in the reflection property in the whole visible light region (400 to 800 nm), and good in the adhesion property to the sealing resin, to hardly cause migration, and which lead frame is stable in the reflection property in the long term since no sulfurization of silver or photocatalytic action causes, by having a metal oxide layer of a metal other than silver, on the surface of the layer composed of silver or a silver alloy, in which the metal oxide layer is colorless and transparent or silver gray in color, with the metal oxide layer preferably being in a thickness of 0.001 to 0.2 µm. The present invention has been attained, based on the finding.

That is, according to the present invention, there is provided the following means:
(1) A lead frame for an optical semiconductor device, comprising: a layer composed of silver or a silver alloy formed on an electrically-conductive substrate; a metal oxide layer of a metal other than silver as an outer layer of the layer composed of silver or a silver alloy, wherein the metal oxide layer is colorless and transparent or silver gray in color, and has a thickness thereof from 0.001 to 0.2 µm.
(2) The lead frame for an optical semiconductor device according to item (1), wherein the layer composed of silver or a silver alloy has a thickness from 0.2 to 5.0 µm.
(3) The lead frame for an optical semiconductor device according to item (1) or (2), wherein the metal oxide layer is composed of an oxide containing at least one element selected from the group consisting of tin, indium, and antimony.
(4) The lead frame for an optical semiconductor device according to any one of items (1) to (3), wherein the layer composed of a silver alloy contains 20 mass% or less in total of at least one element selected from the group consisting of tin, indium, and antimony.
(5) The lead frame for an optical semiconductor device according to any one of items (1) to (3), wherein the layer composed of the silver alloy is comprised of the two layers of: an outer layer which contains 20 mass% or less in total of at least one element selected from the group consisting of tin, indium, and antimony; and an inner layer which contains less than 20 mass% in total of at least one element selected from the group consisting of tin, indium, and antimony.
(6) The lead frame for an optical semiconductor device according to any one of items (1) to (5), wherein the electrically-conductive substrate is composed of a metal or alloy selected from the group consisting of copper, a copper alloy, aluminum, and an aluminum alloy.
(7) The lead frame for an optical semiconductor device according to any one of items (1) to (6), further comprising: at least one intermediate layer composed of a metal or alloy selected from the group consisting of nickel, a nickel alloy, cobalt, a cobalt alloy, copper, and a copper alloy, between the electrically-conductive substrate and the layer composed of silver or a silver alloy.
(8) A method of producing the lead frame for an optical semiconductor device according to any one of items (1) to (7), comprising the steps of: forming the layer composed of silver or a silver alloy on the electrically-conductive substrate; forming a metal layer composed of a metal other than silver, on the outer surface of the layer composed of silver or a silver alloy; and subjecting the metal layer to a heat treatment under an atmosphere of an oxygen concentration of 1,000 ppm or more, at a temperature from 100°C to a melting point of the metal other than silver, thereby to form the metal oxide layer composed of an oxide of the metal other than silver as the surface layer.
(9) The method of producing the lead frame for an optical semiconductor device according to item (8), wherein the step of subjecting the metal layer to the heat treatment causes: formation of the metal oxide layer; and diffusion of a remaining metal, which is the metal of the metal layer and is not oxidized, into the layer composed of silver or a silver alloy, thereby to form a silver alloy layer composed of the remaining metal and silver.
(10) The method of producing the lead frame for an optical semiconductor device according to item (8) or (9), wherein the thickness of the metal layer is from 0.001 to 0.3 µm.
(11) The method of producing the lead frame for an optical semiconductor device according to any one of items (8) to (10), wherein the silver alloy layer composed of the remaining metal and silver contains 20 mass% or less in total of at least one element selected from the group consisting of tin, indium, and antimony.
(12) The method of producing the lead frame for an optical semiconductor device according to any one of items (8) to (10), wherein the silver alloy layer composed of the remaining metal and silver is comprised of the two layers of: a layer which contains 20 mass% or less in total of at least one element selected from the group consisting of tin, indium, and antimony; and a layer which contains less than 20 mass% in total of at least one element selected from the group consisting of tin, indium, and antimony.
(13) The method of producing the lead frame for an optical semiconductor device according to any one of items (8) to (12), wherein the silver alloy layer composed of the remaining metal and silver is formed, by subjecting a plating silver, and a plating of at least one element selected from the group consisting of tin, indium, and antimony, to a reflow treatment.
(14) The method of producing the lead frame for an optical semiconductor device according to any one of items (8) to (13), wherein the layer composed of silver or a silver alloy is formed by plating.
(15) The method of producing the lead frame for an optical semiconductor device according to any one of items (8) to (14), further comprising the step of: forming an intermediate layer by plating, between the electrically-conductive substrate and the layer composed of silver or a silver alloy.
(16) The method of producing the lead frame for an optical semiconductor device according to any one of items (8) to (15), wherein the step of forming the metal layer composed of the metal other than silver, is conducted by plating.
(17) An optical semiconductor device, comprising: the lead frame for an optical semiconductor device according to any one of items (1) to (7); and an optical semiconductor element, wherein the metal oxide layer is provided on a portion where at least the optical semiconductor element is mounted on the lead frame for an optical semiconductor device.

### ADVANTAGEOUS EFFECTS OF INVENTION

In the lead frame of the present invention, by forming, as an outermost layer, the metal oxide layer, which is colorless and transparent or silver gray in color, it is possible to prevent sulfurization and oxidation of the layer composed of silver or a silver alloy (i.e. an inner layer of the metal oxide layer) from being occurred, thereby to prevent a decrease of reflectance. Further, since the silver layer is not formed on the outermost surface (namely, silver is not exposed to the outside), no photocatalytic effect is exhibited. Thus, an optical semiconductor device can be provided, which exhibits a corrosion resistance and the effects in non-decomposition of the gas passed through the resin after resin sealing, and which has a good reflection property in the long term. In the lead frame of the present invention, when the metal oxide layer as an outermost layer is colorless and transparent or silver gray in color, and when the thickness thereof is controlled to be thin as thin as 0.001 to 0.2 µm, the reflection property is obtained, which almost does not decrease due to the metal oxide layer, and which is equivalent to that of conventional silver or a silver alloy.

The method of producing a lead frame of the present invention comprises the steps of: forming the layer composed of silver or a silver alloy on the electrically-conductive substrate; forming the metal layer composed of a metal other than silver, on the surface of the layer composed of silver or a silver alloy; and subjecting the metal layer to the heat treatment under an atmosphere of an oxygen concentration of 1,000 ppm or more, at a temperature from 100°C to a melting point of the metal other than silver, thereby to form the metal oxide layer composed of an oxide of the metal other than silver as the surface layer. If necessary, the method of producing a lead frame of the present invention may further comprise the step of: causing diffusion of a remaining metal, which is the metal of the metal layer and remains as not oxidized, into the layer composed of silver or a silver alloy, thereby to form a silver alloy layer composed of a solid solution of the remaining metal and silver. Thus, the lattice strain is gradually relaxed and the adhesion property is improved. When the metal layer for forming the metal oxide layer is formed, by preferably plating (including wet plating, as well as dry plating, such as vacuum deposition), a thin and fine oxide layer can be readily formed.

Further, in the optical semiconductor device of the present invention, the metal oxide layer is provided at a portion on which an optical semiconductor element of the lead frame for the optical semiconductor devices is at least mounted, and thus the reflectance property can be efficiently obtained at a low cost. As for anther portion on which no optical semiconductor element is mounted, the layer composed of silver or a silver alloy may be exposed to the surface. In this case, the metal oxide layer may be partially formed on the layer composed of silver or a silver alloy, and it may be formed by partial plating, such as stripe plating or spot plating. Production of the lead frame with the thus-partially-formed layer makes it possible to cut off the amount of metal to be used at a portion where the layer is unnecessary, and thus the resultant optical semiconductor device can be friendly to the environment and can achieve reduction of the production costs.
Other and further features and advantages of the invention will appear more fully from the following description, appropriately referring to the accompanying drawings.

### BRIEF DESCRIPTION OF DRAWINGS

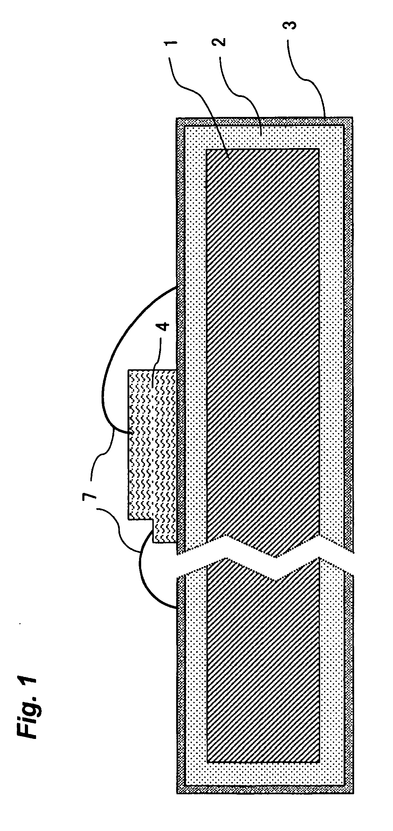

{Fig. 1}
   Fig. 1 is a cross-sectional view schematically illustrating the lead frame for an optical semiconductor device according to a first embodiment of the present invention.
{Fig. 2}
   Fig. 2 is a cross-sectional view schematically illustrating the lead frame for an optical semiconductor device according to a second embodiment of the present invention.
{Fig. 3}
   Fig. 3 is a cross-sectional view schematically illustrating the lead frame for an optical semiconductor device according to a third embodiment of the present invention.
{Fig. 4}
   Fig. 4 is a cross-sectional view schematically illustrating the lead frame for an optical semiconductor device according to a forth embodiment of the present invention.
{Fig. 5}
   Fig. 5 is a cross-sectional view schematically illustrating the lead frame for an optical semiconductor device according to a fifth embodiment of the present invention.
{Fig. 6}
   Fig. 6 is a cross-sectional view schematically illustrating the lead frame for an optical semiconductor device according to a sixth embodiment of the present invention.
{Fig. 7}
   Fig. 7 is a cross-sectional view schematically illustrating the lead frame for an optical semiconductor device according to a seventh embodiment of the present invention the present invention.

### DESCRIPTION OF EMBODIMENTS

Hereinafter, embodiments of the lead frame for an optical semiconductor device of the present invention will be described, using the drawings. Each of the drawings shows a state that the optical semiconductor element is mounted on the lead frame. The respective embodiment is an example, and the scope of the present invention is not limited to those embodiments.

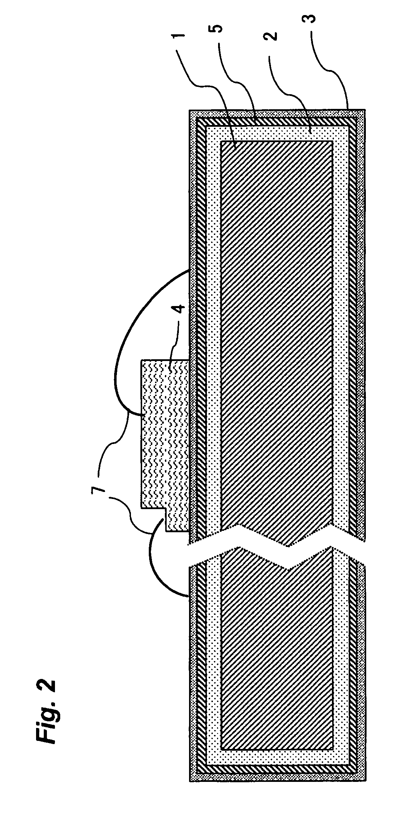

Fig. 1 is a cross-sectional view schematically illustrating the lead frame for an optical semiconductor device according to the first embodiment of the present invention. Fig. 1 shows a state in which an optical semiconductor element 4 is mounted on the lead frame (the same will be applied to Figs. 2 to 7 in the below).
As shown in Fig. 1, the lead frame of the present embodiment has: a layer 2 composed of silver or a silver alloy which layer is formed on an electrically-conductive substrate 1; a metal oxide layer 3 which is composed of a metal oxide, as the outermost layer; and the optical semiconductor element 4 which is mounted partially on the surface of the metal oxide layer 3. In the drawing(s), 7 shows a bonding wire. The lead frame of the present invention is a lead frame for an optical semiconductor device, which is good in the reflection property and good in the adhesion to the sealing resin, and which is excellent in the corrosion resistance and the long-term reliability so as not to cause a decrease of luminance for a long period of time.

The electrically-conductive substrate 1 may be formed, for example, of copper, a copper alloy, aluminum, an aluminium alloy, iron, or an iron alloy. The substrate is preferably composed of a metal or alloy selected from the group consisting of copper, a copper alloy, aluminum, and an aluminium alloy. The use of copper, a copper alloy, aluminum, or an aluminium alloy for forming the electrically-conductive substrate 1 makes the formation of the layer 2 of silver or a silver alloy and the metal oxide layer 3 thereon readily, thereby providing a lead frame which can contribute to a cost reduction.

Further, the lead frame in which the electrically-conductive substrate 1 is composed of the metal or alloy selected from the group consisting of copper, a copper alloy, aluminum, and an aluminum alloy, is excellent in the heat releasing property, because of a favorable heat transfer coefficient which is associated with a favorable electrical conductivity. This is because the generated heat (thermal energy) that is generated upon emission of a light by the optical semiconductor element can be released smoothly to the outside via the lead frame. Owing to those, it is expected to achieve the long service life of the light-emitting element and the long-term stability of the reflectance property.
Further, in the present invention, the term "favorable reflection property (or reflectance property)" means that the reflectance in the whole visible light region with wavelength from 400 nm to 800 nm is 80% or more.

The thickness of the layer 2 composed of silver or a silver alloy is preferably from 0.2 µm to 5.0 µm, more preferably from 0.5 µm to 3.0 µm. This thickness can be realized by adjusting the coating thickness of the layer 2 composed of silver or a silver alloy, and thus the lead frame can be produced at a low cost without using a noble metal more than necessary. When the thickness of the layer 2 composed of silver or a silver alloy is too thin, contribution to the reflectance is not sufficient. On the other hand, when the thickness is too thick, the cost becomes high since the effect is saturated.

Examples of the silver alloy to be used for the layer 2 composed of silver or a silver alloy include a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, a silver-copper alloy, a silver-zinc alloy, and a silver-bismuth alloy. It is preferable to select from the group consisting of a silver-tin alloy, a silver-indium alloy, a silver-rhodium alloy, a silver-ruthenium alloy, a silver-gold alloy, a silver-palladium alloy, a silver-nickel alloy, a silver-selenium alloy, a silver-antimony alloy, and a silver-copper alloy.

The formation of these alloys is relatively readily. Although they are somewhat inferior to pure silver, they can achieve a reflectance of 80% or more in the visible light region. Thus, favorable reflection property for the light in a wide wavelength region can be obtained. The content of silver in the silver alloy is preferably 80 mass% or more. This is because, when the content of silver in a silver alloy becomes too low, the reflectance in the visible light region decreases conspicuously.

The long-term reliability of the layer 2 composed of silver or a silver alloy can be ensured, by forming the metal oxide layer 3, as an outermost layer, which is composed of a metal other than silver and is colorless and transparent or silver gray in color. The metal oxide layer 3 preferably contains an oxide of at least one element of tin, indium, and antimony. The metal oxide layer contains preferably 20 mass% or less, more preferably 1 to 10 mass% of at least one kind of a metal or metalloid (or semimetal) element selected from the group consisting of tin, indium, and antimony, with respect to the mass of the said layer. Sulfurization and oxidation of the layer 2 composed of silver or a silver alloy can be prevented by forming the metal oxide layer 3 colorless and transparent or silver gray in color, and a decrease of reflectance can be prevented. Further, the silver layer is not formed in the outermost surface and thus no photocatalytic effect is exhibited. Thus, an optical semiconductor can be formed, which exerts the corrosion resistance and the non-decomposing effect on the gas passed through the resin after resin sealing, and which is good in the reflection property in the long term. In the present invention, those tin, indium, and antimony are simply called metals collectively. Categorically, antimony may be called semimetal, but this may be simply called metal.

If the metal oxide layer 3 is formed as an outermost layer, the binding of the lead frame with the sealing resin becomes stronger, and thus the adhesion property of the outermost layer to the resin is remarkably improved as compare as compared with the case of the outermost layer of silver or a silver alloy. As a result, the layer composed of silver or a silver alloy is not exposed. Thus, a possibility is reduced in which silver is eluted to cause migration thereof by an affection of humidity or the like, thereby causing a short-circuit trouble in the circuit formed. When the metal oxide layer formed as an outermost layer is colorless and transparent or silver gray in color and the thickness thereof is controlled to from 0.001 µm to 0.2 µm, almost no decrease in reflectance is observed by the color tone and the thickness, and the reflection property is obtained which is equivalent to that of conventional silver or a silver alloys. Based on these actions, when the lead frame of the present invention is used for the optical semiconductor element, for example, a LED, even if the optical semiconductor device is made to continuously emit a light (lighting) for a long period of time of 10,000 hours or more, a decrease of luminance of the optical semiconductor device can be suppressed to about several percents.

The lead frame of the present invention is produced by: forming the layer 2 composed of silver or a silver alloy on the electrically-conductive substrate 1; forming the metal layer composed of a metal other than silver, which metal is to form the target oxide; and subjecting the metal layer to the heat treatment under an atmosphere of an oxygen concentration of 1,000 ppm or more, at a temperature from 100°C to a melting point of the metal, thereby to cause oxidization of the metal in the metal layer to form the metal oxide layer as the surface layer; and if necessary, followed by: causing diffusion of the remaining metal from the metal layer, into the layer composed of silver or a silver alloy, entirely or partially, thereby to form the silver alloy layer composed of a solid solution of the remaining metal and silver. Thus, as illustrated, the metal layer itself disappears and does not remain, and the metal oxide layer 3 is formed, and, if necessary, the silver alloy layer composed of the remaining metal and silver may be formed (as the silver alloy layer composed of the remaining metal and silver, a buffer layer 5 described in below may be formed as one layer, or two layers of the buffer layer 5 and a remaining layer 5A may be formed). It is preferable that the layer 2 composed of silver or a silver alloy is formed by plating. Further, as the optical semiconductor element 4, use may be made of any arbitral optical semiconductor element, such as a LED.

Fig. 2 is a cross-sectional view schematically illustrating the lead frame for an optical semiconductor device according to the second embodiment of the present invention. In contrast to the lead frame of the embodiment shown in Fig. 1, the metallic component of the metal layer partially remains in a layered form, in the vicinity of an interface of the layer 2 composed of silver or a silver alloy and the metal oxide layer 3, to form the layer 5 composed of a silver alloy which is a solid solution of the resultant remaining metal and the surface layer portion of the layer of silver or a silver alloy. The layer 5 is a buffer layer to the layer 2 composed of silver or a silver alloy and the metal oxide layer 3 (hereinafter referred to as the buffer layer 5). Further, a solid solution is formed in a layered manner with a concentration gradient such that the metallic component is reduced toward the side of the layer of silver or a silver alloy, in the vicinity of an interface of the layer of silver or a silver alloy and the metal oxide layer (the said solid solution is a silver alloy which is a silver-metal solid solution of silver and the metal which has been a constituent to form the metal layer). Those allow the lattice strain to be gradually relaxed, thereby to exhibit improvement in the adhesion property.
Herein, the reference signs, not particularly referred to in the explanations for Figs. 2 to 7, each have the same meanings as those in Fig. 1.

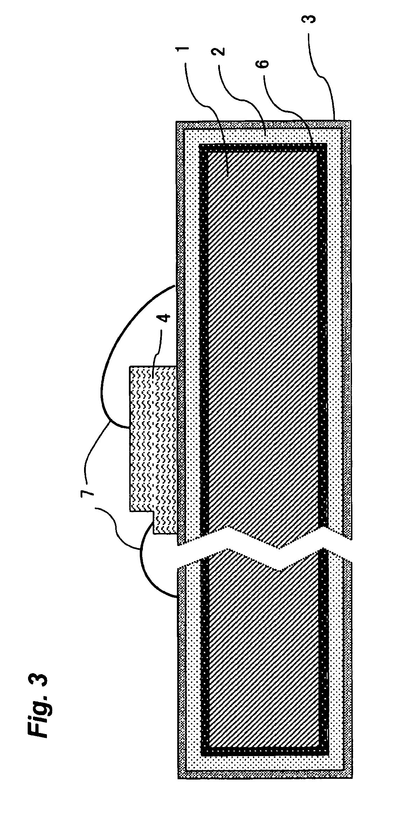

Fig. 3 is a cross-sectional view schematically illustrating the lead frame for an optical semiconductor device according to the third embodiment of the present invention, in which an intermediate layer 6 is provided between the electrically-conductive substrate 1 and the layer 2 composed of silver or a silver alloy, in the lead frame of the embodiment illustrated in Fig. 1.
The intermediate layer 6 is preferably composed of a metal or alloy selected from the group consisting of nickel, a nickel alloy, cobalt, a cobalt alloy, copper, and a copper alloy.
By providing the intermediate layer 6 composed of nickel, a nickel alloy, cobalt, a cobalt alloy, copper, or a copper alloy, between the electrically-conductive substrate 1 and the layer 2 composed of silver or a silver alloy, it is possible to prevent deterioration of the reflectance property due to diffusion of the material constituting the electrically-conductive substrate into the layer composed of silver or a silver alloy, by the heat generated from the optical semiconductor element, and to achieve a long-term, highly-reliable reflectance property.

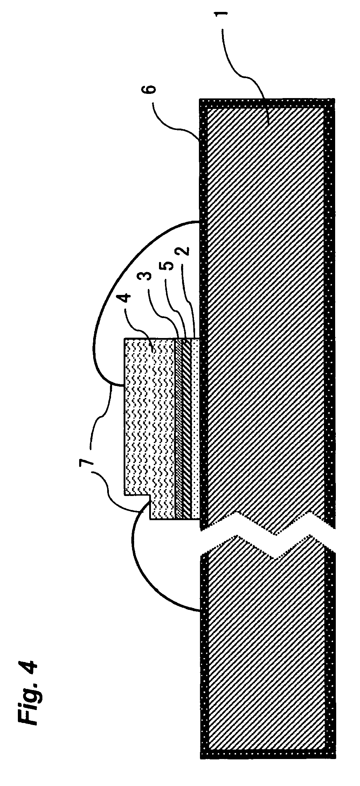

Fig. 4 is a cross-sectional view schematically illustrating the lead frame for an optical semiconductor device according to the forth embodiment of the present invention, and shows a state in which the metal oxide layer 3, the buffer layer 5, and the layer 2 composed of silver or a silver alloy are formed at only a portion on which the optical semiconductor element 4 is mounted. In the present invention, in this way, the metal oxide layer 3, the buffer layer 5, and the layer 2 composed of silver or a silver alloy can be formed only at a portion which may cause the problem of changing its color to black. In the present embodiment, the intermediate layer 6 is formed on the whole surface of the electrically-conductive substrate 1. Alternatively, the intermediate layer 6 may be partially formed on the electrically-conductive substrate 1, as long as the intermediate layer 6 is provided between the electrically-conductive substrate 1 and the layer 2 composed of silver or a silver alloy. Herein, the "partial formation" means that the intermediate layer 6 is formed on the electrically-conductive substrate 1, at the beneath of and in the vicinity of the optical semiconductor element 4.

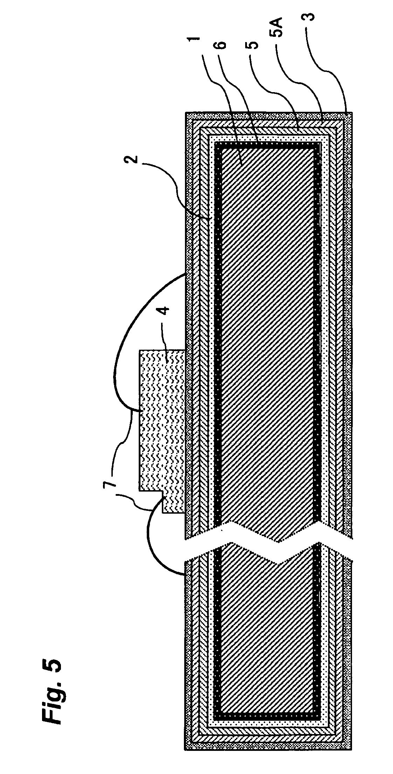

Fig. 5 is a cross-sectional view schematically illustrating the lead frame for an optical semiconductor device according to the fifth embodiment of the present invention, in which the lead frame of the second embodiment having the buffer layer 5, has a layer 5A, which is composed of a silver alloy that is a solid solution of the remaining metal in said silver or silver alloy, between the buffer layer 5 and the metal oxide layer 3, and which has a silver content higher than that of the buffer layer (hereinafter, the layer 5A is also referred to as a remaining metallic component layer or remaining layer 5A).
In the present invention, as shown in Fig. 5, the order of the layers when both of the remaining layer and the buffer layer are formed is the order of: "the electrically-conductive substrate 1 - the intermediate layer 6 - the layer 2 of silver or a silver alloy - the buffer layer 5 - the remaining layer 5A - the metal oxide layer 3". The optical semiconductor element 4 is mounted on the metal oxide layer 3. That is, when the layers are formed, the remaining layer 5A is present at the outer side (as the upper layer) of the buffer layer 5.
Thus, in the present invention, when a metal remains without being oxidized (also called a remaining metal) among the metal of forming the metal layer is present, a layer may be formed, in which the remaining metal is diffused in the layer composed of silver or a silver alloy, to form a layer of a solid solution of the remaining metal in silver of the layer composed of silver or a silver alloy. In the-thus formed silver alloy layer composed of a solid solution of silver and the (remaining) metal, the concentration gradient of the metal other than silver is reduced from the side of the metal oxide layer of the outermost layer toward the side of the layer of silver or a silver alloy layer of the inner layer. The silver alloy layer is formed of only the buffer layer 1, or alternatively, of the two layers of the buffer layer and the remaining layer. Herein, the buffer layer and the remaining layer are distinguished by the content of silver. A layer containing 80 mass% or more of silver is defined as the buffer layer, and a layer containing less than 80 mass% of silver is defined as the remaining layer.
Specifically, the metal, such as indium and tin, has a concentration gradient such that the content is gradually reduced from the side of the outermost layer (side of the metal oxide layer 3). Thus, the metal, such as indium and tin, is condensed (present in a high concentration) near the outermost layer. That is, the silver concentration is lower. In the present invention, the remaining layer 5 means a region where the concentration of the metal, such as indium and tin, is more than 20 mass%, namely, the silver concentration is less than 80 mass%. On the other hand, the buffer layer means a region where the concentration of the metal, such as indium and tin, is 20 mass% or less, namely, the silver concentration is 80 mass% or more.
Herein, the buffer layer 5 and the layer 2 composed of a silver alloy may be the same one layer or different layers. The case where the buffer layer 5 and the layer 2 composed of a silver alloy are the same one layer is the case where the original composition of the silver alloy layer (2) is the same as that of the buffer layer (5). For example, when a silver layer as a lower layer and a layer of a metal other than silver (for example, In) as an upper layer of the silver layer, are formed by plating, respectively, and the resultant layers are subjected to a reflow treatment to cause alloying thereof, a silver alloy layer (for example, an Ag-In layer) is obtained as a layer. If the content of silver is 80 mass% or more, the layer has to be the buffer layer. On the other hand, the case where the buffer layer 5 and the layer 2 composed of a silver alloy are the different layers is the case where the metal for forming the solid solution in the buffer layer 5 and the metal in the layer 2 composed of a silver alloy are different kinds of metals from each other.
The description will be made in detail, with respect to the case where the buffer layer is equivalent to the original silver alloy layer, namely, the original silver alloy layer becomes the buffer layer as it is. When a silver alloy layer is formed, followed by coating with indium or the like thereon and heating for diffusion, for example, as shown in the following examples, the "silver alloy layer" and "buffer layer" after heating shown in the tables are the same. That is, in the case where the silver alloy layer is provided by a reflow treatment in the examples, the respective numerical value is indicated in the column of the "silver alloy layer" after heating, and the mark "←" in the sense of "being the same as the left-sided (or preceding) column" is indicated in the column of the buffer layer. Incidentally, in these examples, indium or the like is applied very thinly after reflow-formation of the silver alloy layer, followed by the heat treatment at a low temperature. Thus, no drastic diffusion occurs, and the resultant indium or the like coating on the silver alloy layer becomes the oxide layer as it is.
The remaining layer and the buffer layer is composed of a silver alloy which forms a solid solution of the remaining metal (Sn, In, or Sb) with silver. The remaining metal does not remain as a single layer, and the remaining metal is not oxidized. Thus, no oxygen is contained, and no element other than the remaining metal and silver is contained, in those layers.

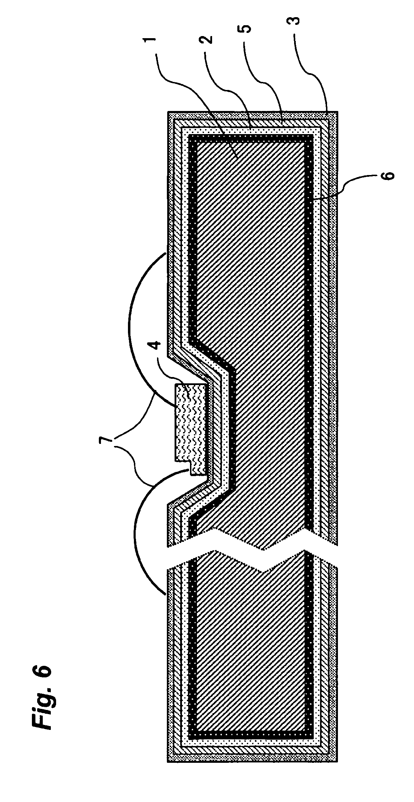

Fig. 6 is a cross-sectional view schematically illustrating the lead frame for an optical semiconductor device according to the sixth embodiment of the present invention, in which a recess is provided in the electrically-conductive substrate 1 and the optical semiconductor element 4 is mounted at the inside of the recess. As in this embodiment, the lead frame for an optical semiconductor device of the present invention can also be applied to such a shape of lead frame that the recess is provided to improve the light-concentrating property.

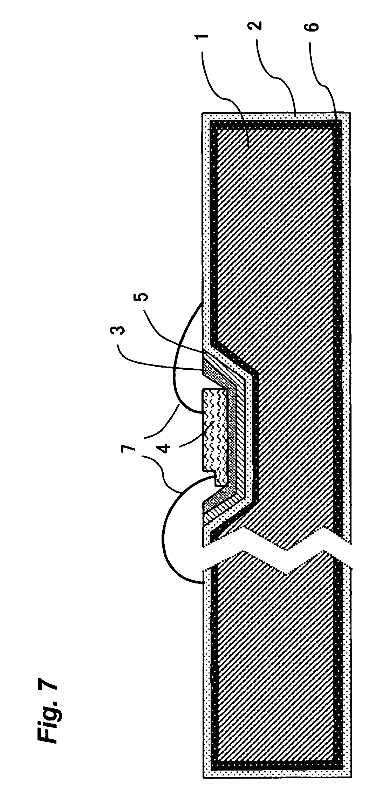

Fig. 7 is a cross-sectional view schematically illustrating the lead frame for an optical semiconductor device according to the seventh embodiment of the present invention, in which a recess is provided in the electrically-conductive substrate 1, the optical semiconductor element 4 is mounted at the inside of the recess, and the metal oxide layer 3 and the buffer layer 5 are formed only at the recess. In this way, in the lead frame having a recess, as the metal oxide layer 3 and the buffer layer 5 are provided only at the portion contributing to the reflection of a light emitted by the optical semiconductor element, it is also possible to improve the corrosion resistance only at the reflecting part appropriately.

Other embodiments of the present invention include followings:
(1) For example, the lead frames of the embodiments shown in any one of Figs. 1 to 3 or Figs. 5 to 7 may be partially formed, similar to the lead frame of the embodiment shown in Fig. 4.
(2) The lead frame of the embodiment shown in Fig. 3 may have the buffer layer 5.
(3) The lead frames of the embodiments shown in any one of Figs. 4 to 7 may not have the buffer layer 5.
(4) The lead frame of any one of the embodiments having the buffer layer 5 (both illustrated and unillustrated embodiments are included) may have the remaining layer 5A, between the buffer layer 5 and the metal oxide layers 3.
(5) In the lead frame of any one of the embodiments having the buffer layer 5 (both illustrated and unillustrated embodiments are included), the entire layer 2 composed of silver or a silver alloy may be the buffer layer 5. Such an embodiment is the case, for example, where the silver layer 2 as the lower layer and the layer of a metal other than silver (for example, In layer) as the upper layer of the layer 2 are formed separately by plating, the resultant two layers are subjected to reflow treatment before the heat treatment for oxidizing, the two layers are completely alloyed to form a silver alloy layer, which silver alloy layer corresponds to the buffer layer 5 from the definition of the content of silver in the silver alloy.
When the above cases are summarized, in the lead frame of the present invention, they are classified into three cases:
only the "metal oxide layer 3" is formed;
the "metal oxide layer 3" and the "buffer layer 5" are formed; or
the "metal oxide layer 3", the "buffer layer 5", and the "remaining layer 5A" are formed, from the viewpoint of the metal layer composed of a metal other than silver. In each of the above cases, the thus-obtained lead frame may have the buffer layer (5), in place of the layer (2) composed of silver or a silver alloy. Each layer containing the metal oxide layer 3 may be partially formed, as typically shown in Fig. 4.

In the production of the lead frame for a semiconductor device, any of arbitrary methods can be used. The layer 2 composed of silver or a silver alloy and the intermediate layer 6 are formed preferably by plating. The metal layer for forming the metal oxide layer 3 is formed preferably by plating (wet plating or dry plating, such as vacuum deposition).

In the lead frames of the embodiments of the present invention shown in Figs. 1 to 7, sulfurization and oxidation of the layer composed of silver or a silver alloy can be prevented, by forming, as an outermost layer, the metal oxide layer which has a thickness of 0.001 to 0.2 µm and which is colorless and transparent or silver gray in color, which allows to prevent any decrease of reflectance. Further, since silver is not exposed to the outside of the outermost surface, no photocatalytic effect is exhibited. Thus, an optical semiconductor can be formed, which exerts the corrosion resistance and non-decomposing effect on the gas passed through the resin after resin sealing, and which is good in the reflection property in the long term.

In the lead frame of a present invention, since the outermost layer is the metal oxide layer 3, the adhesion property with the sealing resin is improved as compared with that of the case of silver or silver alloy. As a result, the layer composed of silver or a silver alloy is not exposed. Thus, a possibility is reduced in which silver is eluted to cause migration by an influence of humidity or the like, thereby causing a short-circuit trouble in the circuit formed.

When the metal oxide layer 3 formed as an outermost layer is colorless and transparent or silver gray in color and the thickness thereof is controlled to 0.001 to 0.2 µm, almost no decrease in reflectance is observed due to the color tone and the thickness, and the reflection property equivalent to that of conventional silver or silver alloys is obtained. By those actions, when the lead frame of the present invention is used for an optical semiconductor device, for example, an LED element, even if the optical semiconductor device emits a light (lights up) over a long period of time (10,000 hours or more), a decrease of luminance of the optical semiconductor device can be controlled down to about several percents.

Further, by forming the electrically-conductive substrate 1 with copper, a copper alloy, aluminum, or an aluminum alloy, the lead frame of the present invention can be made to have a favorable reflectance property, forming of the layers on the surface thereof can be conducted readily. Furthermore, the lead frame of the present invention is excellent in the heat releasing property (heat dissipation), this is because the generated heat (thermal energy) that is generated upon emission of a light by the light-emitting element can be released or dissipated smoothly to the outside via the lead frame. Based on those, it is expected to achieve the long service life of the light-emitting element and the long-term stability of the reflectance property.

Further, in the lead frame of the present invention, at least one intermediate layer composed of a metal or alloy selected from the group consisting of nickel, a nickel alloy, cobalt, a cobalt alloy, copper, and a copper alloy is formed, between the electrically-conductive substrate and the layer composed of silver or a silver alloy. Thus, it is possible to prevent deterioration of the reflectance property caused by diffusion of the material for forming the electrically-conductive substrate into the layer composed of silver or a silver alloy due to heat generated when the light-emitting element emits a light; the reflectance property becomes highly reliable over a long period of time; and the adhesion property between the electrically-conductive substrate and the layer composed of silver or a silver alloy is also improved. The thickness of the intermediate layer can be determined, taking the pressing property, the production costs, the productivity, the heat resistance, and the like, into consideration. Under the general conditions, the total thickness of the intermediate layers is preferably 0.2 to 2.0 µm, more preferably 0.5 to 1.0 µm. The intermediate layer may be formed of a plurality of layers, but, in general, the number of intermediate layers is preferably 2 or less, taking the productivity into consideration. In the case of forming 2 or more of the intermediate layers, when the layers are formed of the above-mentioned metal or alloy (constitution materials of the intermediate layer), and the total thickness is set within the above-mentioned range, the layers may be formed of the same material or different materials with each other, and the thickness of the respective layer may be the same as or different from each other.

In the lead frame of the present invention, by setting the thickness of the layer composed of silver or a silver alloy to 0.2 µm or more, a long-term reliability can be ensured. Further, by setting the thickness of the layer 2 composed of silver or a silver alloy to 5.0 µm or less, cost reduction can be achieved without using a noble metal more than necessary. This is because that an effect of the long-term reliability is saturated when the thickness of the layer composed of silver or a silver alloy reaches 5.0 µm. The thickness of the layer 2 composed of silver or a silver alloy is preferably from 0.2 to 5.0 µm, more preferably from 0.5 to 3.0 µm. At least one layer of silver or a silver alloy may be formed, and the layer may be comprised of a plurality of layers. Taking the production cost aspect into consideration, it is preferable that the number of layers is two or less. In the case of forming 2 or more of the layers composed of silver or a silver alloy, when the layers are formed of silver or the silver alloy, and the total thickness is set within the above-mentioned range, the layers may be formed of the same material or different materials with each other, and the thickness of the respective layer may be the same as or different from each other.

In the lead frame of the present invention, when the metal oxide layer 3 formed as the outermost layer is preferably composed of a metal oxide containing at least one element of tin, indium, and antimony, the thus-formed metal oxide layer is colorless and transparent or shows silver gray in color, and has difficulty in reducing the reflectance, resulting in favorable corrosion resistance and productivity. From the viewpoint of reliability, the long-term reliability can be ensured without any decrease in light reflectance, by setting the thickness of the outermost layer from 0.001 µm to 0.2 µm. This is because the corrosion resistance may become insufficient if the thickness of the metal oxide layer is too thin, and the reflectance in the visible light region may be conspicuously decreased if the thickness of the metal oxide layer is too thick. The layer thickness of the metal oxide layer is preferably within the range from 0.005 to 0.05 µm.

In order to form the metal oxide layer with a thickness from 0.001 µm to 0.2 µm as the surface layer of the lead frame, it is preferable that, first, the metal layer with a thickness of 0.001 to 0.3 µm is formed on the layer of silver or a metal alloy which is provided on the electrically-conductive substrate or on the intermediate layer provided on the layer of silver or a metal alloy, and then the metal of the metal layer is oxidized to obtain a desired metal oxide. When the metal is applied directly onto the silver layer and the resultant layer is subjected to the heat treatment, an excessive amount of the remaining metallic component for forming the oxide layer may be caused (remained without being oxidized). In this case, if the total of the thickness of the metal oxide layer (oxide layer) and the thickness of the remaining metal layer is more than 0.2 µm, the reflection property may be lowered. Thus, it is important not to decrease the reflectance while maintaining the favorable adhesion property between the metal oxide layer and the layer composed of silver or a silver alloy. Further, it is also important to form the metal layer with 1- to 20-fold the thickness of the oxide layer to be formed and the maximum layer thickness of not more than 0.3 µm. The layer thickness of the metal layer is preferably from 0.001 to 0.3 µm, more preferably from 0.005 to 0.1 µm.

Hereinafter, the description will be made on the method of producing the lead frame according to the embodiments of the present invention. The method of producing the lead frame according to the embodiments of the present invention comprises the steps of: forming the layer composed of silver or a silver alloy on the electrically-conductive substrate; forming the metal layer composed of a metal other than silver, on the surface of the layer composed of silver or a silver alloy; subjecting the metal layer to the heat treatment under an atmosphere of an oxygen concentration of 1,000 ppm or more, at a temperature from 100°C to a melting point of the metal other than silver, thereby to form the metal oxide layer composed as the surface layer; and causing diffusion of the remaining metal into the layer composed of silver or a silver alloy, in the case where the remaining metal of the metal layer is present, which is not oxidized by the heat treatment and remained.

The oxygen concentration in the atmosphere is preferably 1,000 ppm or more to form the metal oxide layer, and the heat treatment can be conducted in the air. The heat treatment temperature is preferably from 100 to 300°C, more preferably from 100 to 200°C. It is preferable to select the temperature such that the base material would be neither softened nor deteriorated by the heat treatment. It is desirable that the heat treatment is appropriately conducted within a range of 1 second to 48 hours. The thickness of the metal oxide layer can be controlled by appropriately adjusting the oxygen concentration and the heat treatment time period. By causing the remaining metal to be completely or partially diffused into the silver or silver alloy by the heat treatment, a silver alloy with a concentration gradient is formed, such that the metallic component is reduced toward the side of the silver or silver alloy, in the vicinity of the interface of the layer of silver or a silver alloy and the metal oxide layer. This allows the lattice strain to be gradually relaxed, thereby improvement in the adhesion property. Herein, even if a silver alloy is newly formed by silver or a silver alloy and the metallic component, the light reflectance is not reduced. This can be considered that the silver alloy thus formed is added to the thickness of the layer of silver or a silver alloy originally formed.

When an excessive amount of the metallic component for forming the oxide layer is fully diffused into the layer of silver or a silver alloy (i.e. only the buffer layer 5 is formed, when the component is fully diffused), a decrease in reflectance is small, which is desirable. When the metallic component is not fully diffused into the layer of silver or a silver alloy (i.e. both of the buffer layer and the remaining layer are formed, when the component is not fully diffused), the total thickness of the oxide layer and the layer of the remaining metallic component is desirably 0.2 µm or less. When the thickness is thicker than the range, it is difficult to effectively utilize the reflectance of silver or a silver alloy, and the light reflectance tends to be decreased conspicuously. As the heat treatment, a batch treatment and a heat treatment, such as in-line, can be appropriately selected.

In the method of producing the lead frame of the embodiments of the present invention, the thickness of the layer composed of silver or a silver alloy can be readily adjusted, by forming the layer composed of silver or a silver alloy by plating. Examples of other forming methods include cladding and sputtering, but the control of the thickness is difficult when using these methods and the production costs become high.

Further, in the method of producing the lead frame of the embodiments of the present invention, by forming the layer composed of silver or a silver alloy and the intermediate layer through plating, it is possible to adjust the thickness of the layer composed of silver or a silver alloy and the intermediate layer readily. Examples of other forming methods include cladding and sputtering, but the control of the thickness is difficult when using these methods and the production costs become high.

In the method of producing the lead frame of the embodiments of the present invention, a thin and fine oxide layer can be effectively formed, by forming the metal layer for forming the metal oxide layer by plating (wet plating or dry plating, such as vacuum deposition). This is an important procedure to improve the corrosion resistance of the layer composed of silver or a silver alloy. Examples of other forming methods include cladding, but since this cladding is a mechanical coating method, it is difficult to obtain a fine and uniform coating layer due to an affection of a concavo-convex portion formed by rolling, and it is also very difficult to stably form a thin layer with a thickness of 0.2 µm or less.

As for in the optical semiconductor device of the embodiments of the present invention, when the metal oxide layer is provided at at least the portion on which the optical semiconductor element is mounted in the lead frame for an optical semiconductor device (partially formed, as described above, as typically shown in Fig. 4 or Fig. 7), the reflectance property can be efficiently obtained at a low cost. This is because, if deterioration of the layer composed of silver or a silver alloy can be prevented, by forming the metal oxide layer on only a mounted portion of the optical semiconductor element, the reflectance property is not largely affected.

Herein, for example, as for the portion on which the optical semiconductor device is not mounted, the layer composed of silver or a silver alloy may be exposed to the surface. In this case, the metal oxide layer may be partially formed on the layer composed of silver or a silver alloy, and, for example, the metal layer for forming the metal oxide layer may be formed by partial plating, such as stripe plating or spot plating. Production of the lead frame with the thus-partially-formed metal oxide layer makes it possible to cut off the amount of metal for use at an unnecessary portion, and thus the resultant optical semiconductor device can be friendly to the environment and can achieve reduction of the production costs. Herein, when the layer composed of silver or a silver alloy is exposed to the surface, solder wettability is readily ensured, and effects useful in mounting can be obtained.

### EXAMPLES

The present invention will be described in more detail based on examples given below, but the invention is not meant to be limited by these.

### (Example No. 1)

In Example No. 1, the respective electrically-conductive substrate, as shown in Tables 1-1 and 1-2, with thickness 0.2 mm and width 50 mm, was subjected to the following pretreatments, the following plating, and then the heat treatment under an atmospheric in the air at 100 to 200°C for 1 to 48 hours, by using a thermostat (manufactured by ESPEC), thereby to obtain the lead frames of Examples 1 to 48 according to the present invention (Ex.), Conventional example 1 (Conv. ex.), and Comparative examples 1 to 10 (Comp. ex.), respectively, having the respective structure as shown in Tables 1-1 and 1-2. When the "reflow" treatment shown in the tables was performed, a silver layer and a layer of a metal other than silver (any one of In, Sn, and Sb) were formed, using the respective plating liquid in advance, followed by, before the heat treatment, subjecting the thus-formed layers to the reflow treatment, thereby to form a layer of a silver alloy (any one of Ag-In, Ag-Sn, and Ag-Sb). Then, a metal layer was formed thereon, and the resultant layer was subjected to the heat treatment in the same manner as described above, thereby to form a metal oxide layer. The resultant lead frame is the lead frame of the first embodiment shown in Fig. 1, unless otherwise specified.
The description will be made in detail, with respect to the case where the buffer layer was equivalent to the original silver alloy layer, namely, the original silver alloy layer became the buffer layer as it was. When the silver alloy layer was formed and the resultant layer was coated with indium thereon, followed by the heating for diffusion, the "silver alloy layer" and "buffer layer" after the heating were the same. Specifically, this corresponded to the case where the silver alloy layer was provided by the reflow treatment. Incidentally, in these examples, indium or the like was applied very thinly after the reflow formation of the silver alloy layer, followed by the heat treatment conducted at a low temperature. Thus, no drastic diffusion occurred, and the resultant indium or the like coating on the silver alloy layer became the oxide layer as it was.

The thickness of the intermediate layer and the thickness of the layer composed of silver or a silver alloy, as shown in Tables 1-1 and 1-2, each represent an average value of thicknesses (i.e. an arithmetic average of measured values at arbitrary ten points). The thickness of each layer was measured, using a fluorescent-X-ray film thickness measuring apparatus (trade name: SFT9400, manufactured by Seiko Instruments Inc. (SII)).

Herein, out of materials used as the electrically-conductive substrates, "C19400 (a Cu-Fe-based alloy material: Cu-2.3Fe-0.03P-0.15Zn)", "C52100 (phosphor bronze: Cu-8Sn-P)", and "C77000 (nickel silver: Cu-18Ni-27Zn)" represent copper alloy substrates, and the numerical values following 'C' indicate types based on CDA (Copper Development Association) standards. The unit of the value of each element is based on mass%.

Further, "A1100", "A2014", "A3003", and "A5052" represent aluminum or aluminum alloy substrates. The ingredients thereof are stipulated in Japanese Industrial Standards (e.g., JIS H 4000:2006).
Furthermore, "SUS304" and "42 alloy" represent iron-based substrates, in which "SUS304" represents a stainless steel of the type as stipulated in Japanese Industrial Standards (JIS G 4305:2005) (Fe-18Cr-8Ni-0.06C), and "42 alloy" represents an iron alloy containing NI in an amount of 42%.

As the pretreatments, out of the electrically-conductive substrates, the copper alloy substrate and the iron-based substrate were subjected to the following electrolytic degreasing and then to the following acid pickling. On the other hand, the aluminum substrate and the aluminum alloy substrate were subjected to the following electrolytic degreasing, the following acid pickling, and the following zincate conversion.

### (Pretreatment conditions)

### [Electrolytic degreasing]

Degreasing liquid: NaOH 60g/L
Degreasing conditions: 2.5 A/dm², temperature 60°C, degreasing time period 60 seconds
[Acid pickling]
Acid pickle: 10% sulfuric acid
Acid pickling conditions: 30 seconds dipping, room temperature
[Zincate conversion] Conducted when the substrate was of aluminum Zincate conversion liquid: NaOH 500 g/L, ZnO 100 g/L, dihydroxysuccinic acid (C₄H₆O₆) 10 g/L, FeCl₂ 2 g/L
Treatment conditions: 30 seconds dipping, room temperature

Compositions of plating liquids and plating conditions in each of the plating applied to in Example No. 1 are described below.

### (Plating conditions)

[Cu plating]
Plating liquid: C_{U}SO₄-5H₂O 250 g/L, H₂SO₄ 50 g/L, NaCl 0.1 g/L
Plating conditions: Current density 6 A/dm², temperature 40°C
[Ni plating]
Plating liquid: Ni(S0₃NH₂)₂·4H₂O 500 g/L, NiCl₂ 30 g/L, H₃BO₃ 30 g/L
Plating conditions: Current density 5 A/dm², temperature 50°C
[Co plating]
Plating liquid: Co(SO₃NH₂)₂·4H₂O 500 g/L, CoCI₂ 30 g/L, H₃BO₃ 30 g/L
Plating conditions: Current density 5 A/dm², temperature 50°C

[Ag plating]
Plating liquid: AgCN 50 g/L, KCN 100 g/L, K₂CO₃ 30 g/I
Plating conditions: Current density 1 A/dm², temperature 30°C
[Ag-Sn alloy plating] (No reflow treatment)
Plating liquid: KCN 100 g/L, NaOH 50 g/L, AgCN 10 g/L, K₂Sn(OH)₆ 80 g/L
Plating conditions: Current density 1 A/dm², temperature 40°C
[Ag-Pd alloy plating] (No reflow treatment)
Plating liquid: KAg[CN]₂ 20 g/L, PdCl₂ 25 g/L, K₄O₇P₂ 60 g/L, KSCN 150 g/L
Plating conditions: Current density 0.5 A/dm², temperature 40°C
[Ag-In alloy plating] (No reflow treatment)
Plating liquid: KCN 100 g/L, NaOH 50 g/L, AgCN 10 g/L, InCl₃ 1 to 20 g/L
Plating conditions: Current density 2 A/dm², temperature 30°C

[Sn plating]
Plating liquid: SnSO₄ 80 g/L, H₂SO₄ 80 g/L
Plating conditions: Current density 2 A/dm², temperature 30°C
[In plating]
Plating liquid: InCl₃ 45 g/L, KCN 150 g/L, KOH 35 g/L, dextrin 35 g/L
Plating conditions: Current density 2 A/dm², temperature 20°C
[Sb plating]
Plating liquid: KSb(C₄H₂O₆)·1.5H₂O 100 g/L, KNaC₄H₄O₆·4H₂O 50 g/L, KOH 10 g/L
Plating conditions: Current density 1 A/dm², temperature 30°C
The Sn plating, In plating, and Sb plating were conducted after the Ag plating, and the resultant plated samples were subjected to the reflow treatment, to alloy into an Ag-Sn alloy, an Ag-In alloy, and an Ag-Sb alloy, respectively.

### (Evaluation method)

The thus-obtained lead frames of Examples according to the present invention, Comparative examples, and Conventional example were evaluated in the following experiments and criteria. The results are shown in Tables 2-1 and 2-2.

### (1) Reflectance measurement:

With a spectrophotometer (U-41 00 (trade name, manufactured by Hitachi High-Technologies Corporation)), continuous measurement was made on the total reflectance over a wavelength range of 400 nm to 800 nm. Out of the results, the reflectance (%) at 400 nm, 600 nm, and 800 nm are shown in Tables 2-1 and 2-2.

### (2) Metal oxide layer thickness:

Analysis in the depth direction was conducted using AES analyzer (trade name: Model-680, manufactured by ULVAC-PHI), and the thickness of the metal oxide layer was calculated by converting the resultant sputtering rate into the thickness. The thus-measured thickness of each of the metal oxide layer, the remaining layer, and the buffer layer are shown in Tables 1-1 and 1-2. From the measured results, a region with a silver content of less than 80 mass% was defined as the remaining layer, and a region with a silver content of 80 mass% or more was defined as the buffer layer.

### (3) Corrosion resistance:

The rating number (RN) was evaluated on the corroded state 24 hours after the sulfurization test (as stipulated under JIS H8502), at H₂S 3 ppm. The results are shown in Tables 2-1 and 2-2. Herein, the case where the rating number is 9 or more means that a decrease of luminance is as small as about several percents even if the optical semiconductor element (LED) is lighted up for 40,000 hours.

### (4) Reflectance measurement after the sulfurization test: Reflectance measurement:

Continuous measurement of the total reflectance over a wavelength range of 400 to 800 nm was conducted, with a spectrophotometer (trade name: U-4100, manufactured by Hitachi High-Technologies Corporation). Out of the results, the ratio (%) of the reflectance at 600 nm after the sulfurization test to that before the sulfurization test was determined, as an index of the corrosion resistance. The results are shown in Tables 2-1 and 2-2.

### (5) Heat releasing property (heat conductivity):

When the electrical conductivity of the electrically-conductive substrate was 10% or more under IACS (International Annealed Copper Standard), it is judged to be high in the heat conductivity and "good", while when the electrical conductivity was less than 10%, it is judged to be low in the heat conductivity and "poor". The results are shown in Tables 2-1 and 2-2. This is because, the electrical conductivity is almost proportional to the heat conductivity, and the electrical conductivity of 10% or more under IACS is determined as favorable in the heat conductivity and high in the heat releasing property. This is also because when the electrical conductivity of the electrically-conductive substrate is high, heat generation from the electrically-conductive substrate itself can be suppressed, which is preferred. Please note that this item is shown for reference. When the evaluation criteria on each of the items (1) to (4) above are satisfied, even if the evaluation criterion on the item (5) above is not satisfied, the sample is practically satisfactory, by selecting the application that does not require a high heat-releasing property.

With respect to the case where the "silver alloy layer" and "buffer layer" after heating, as shown in the tables, are the same, namely, the case where the silver alloy layer is provided by the reflow treatment, the numerical values for the thickness or the like were indicated in the column of the "silver alloy layer" after heating and the mark "←" in the sense of "being the same as to the left (the same as that of the silver alloy layer) was indicated in the column of the buffer layer.

{Table 1-1}

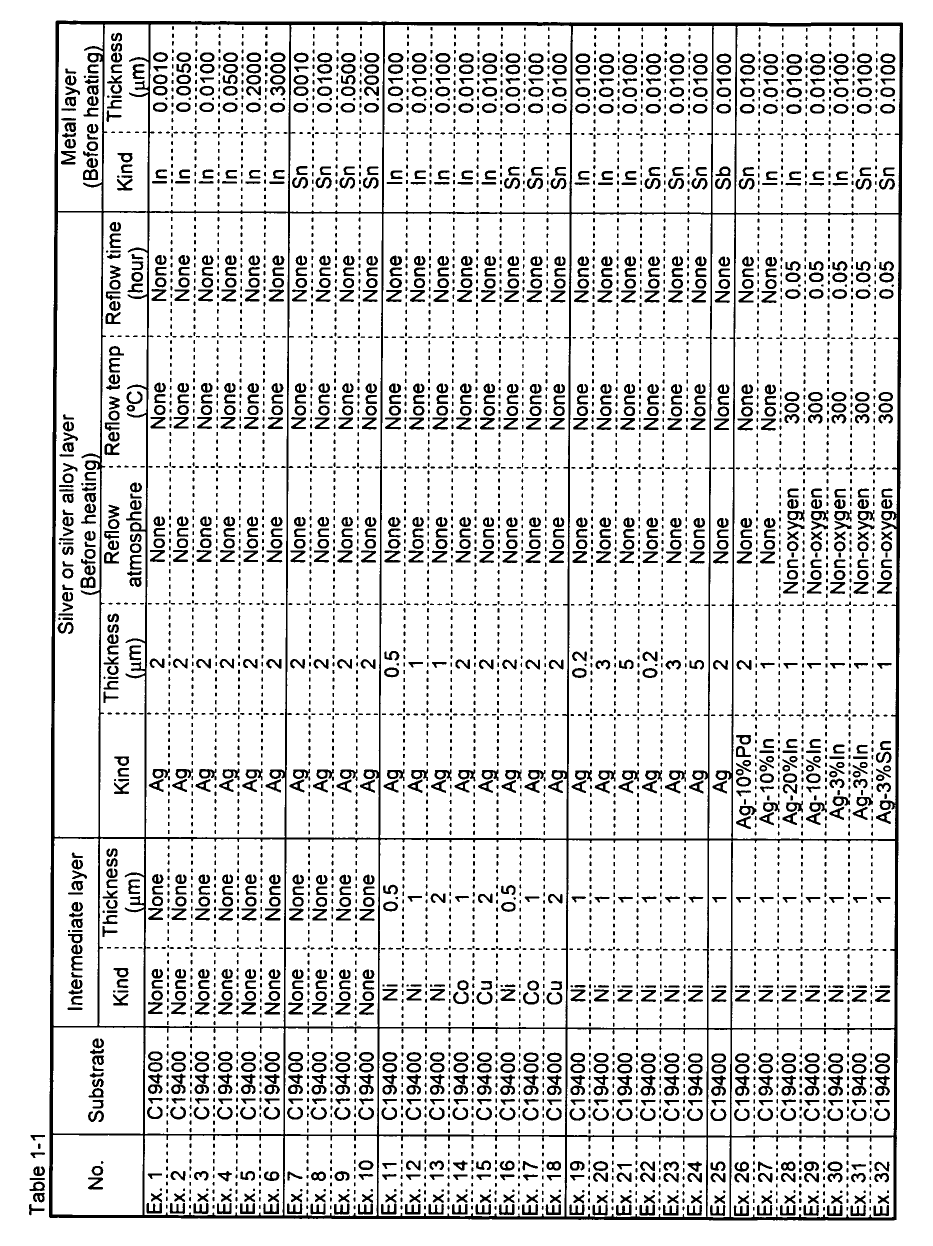

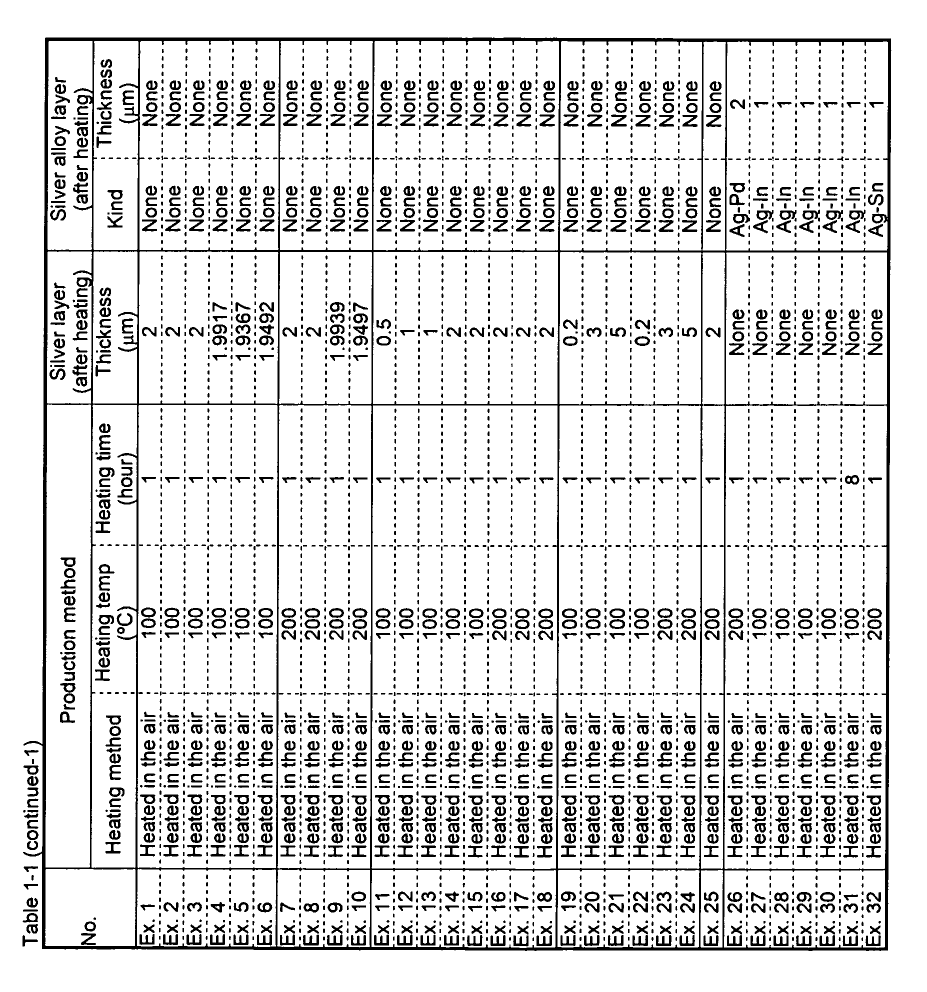

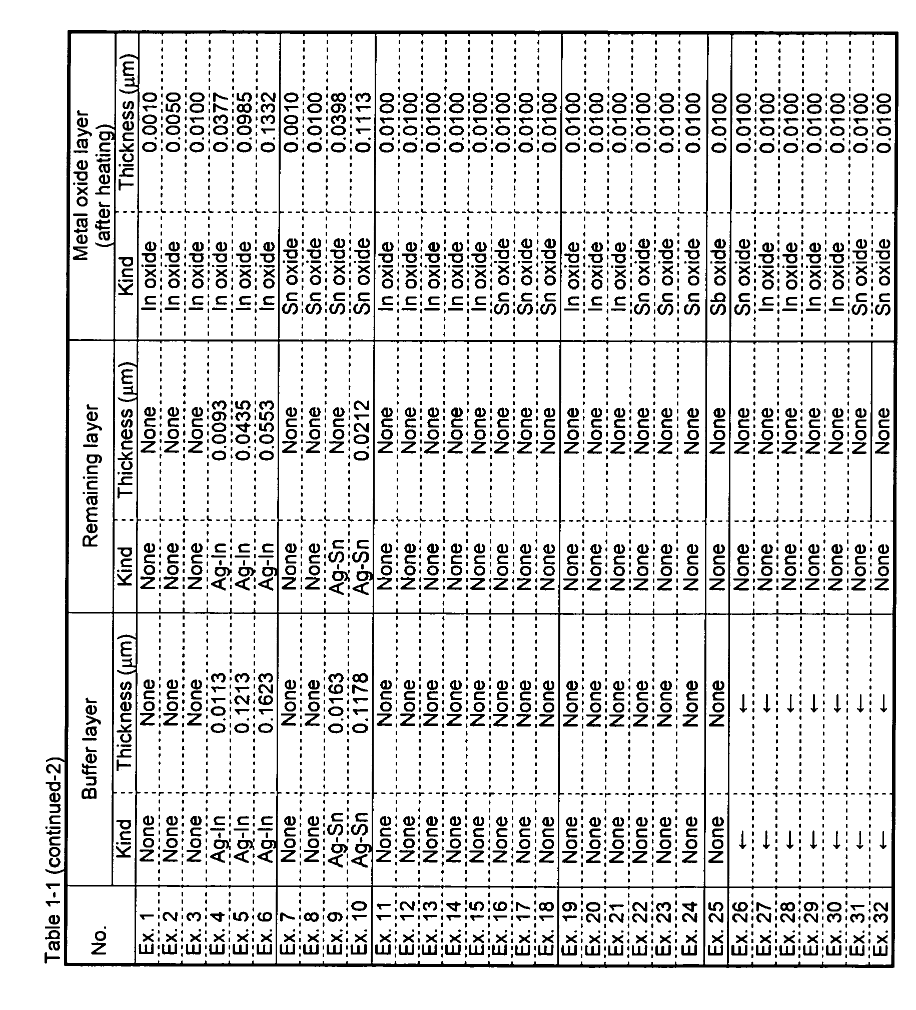

{Table 1-2}

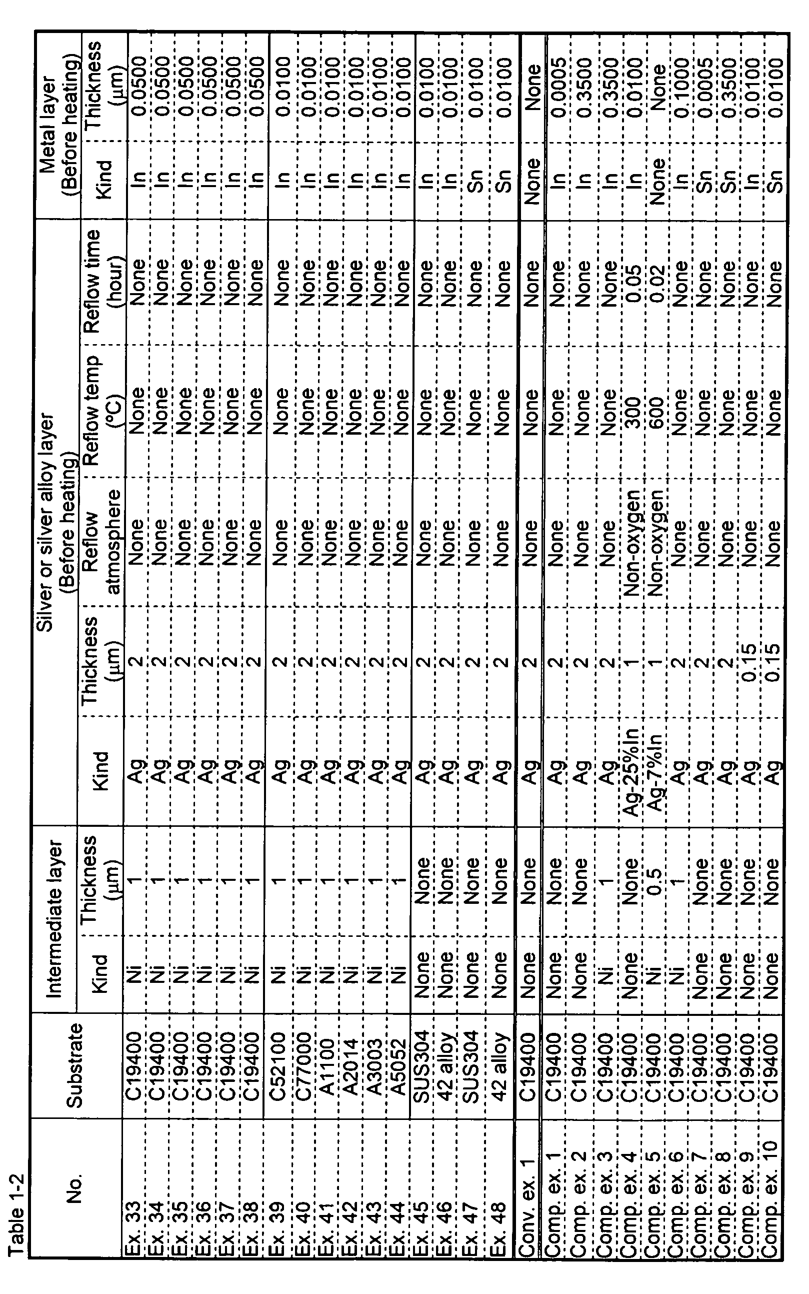

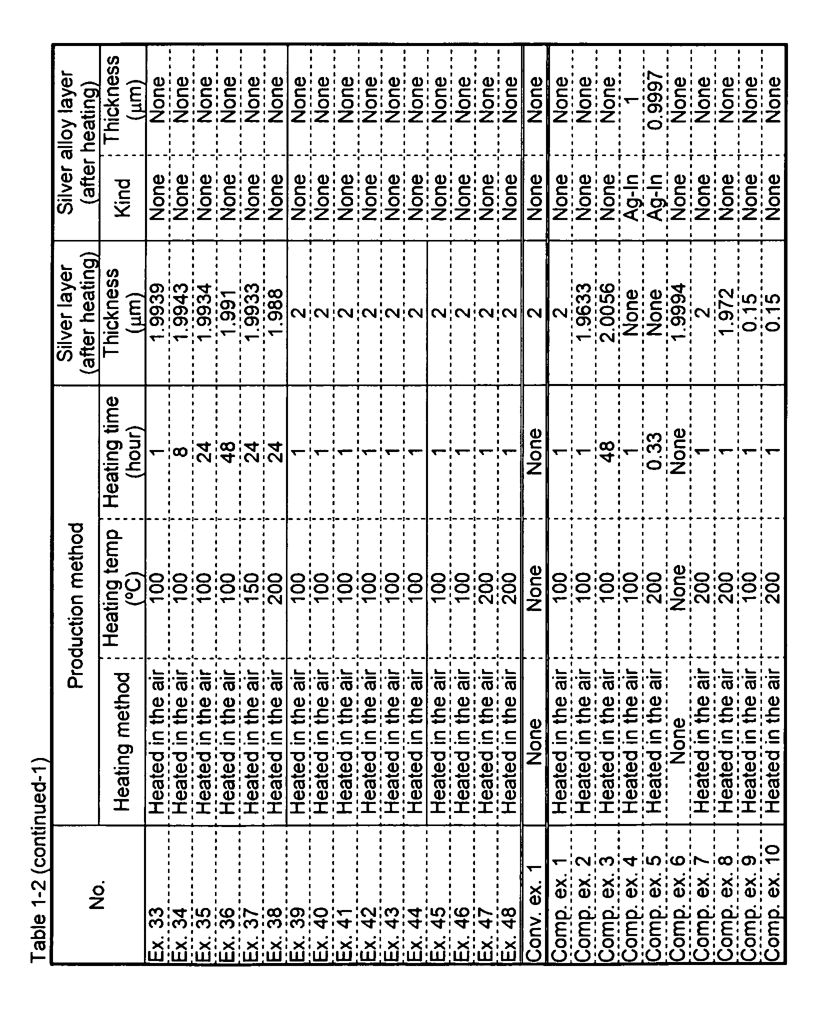

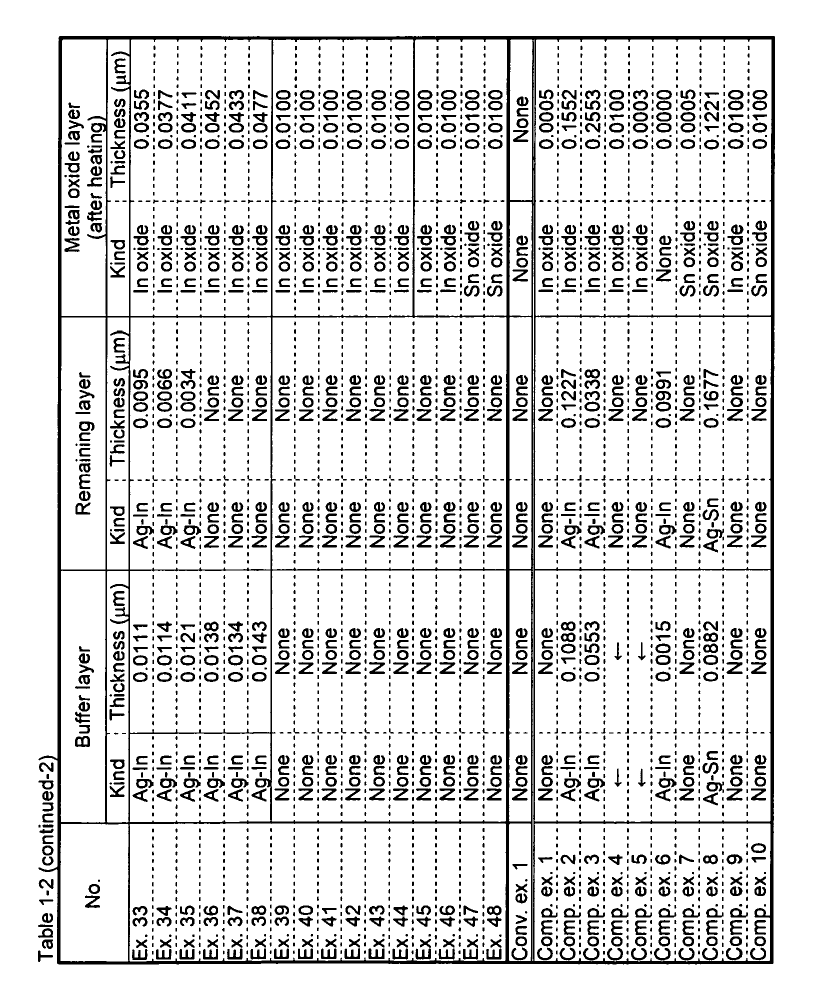

{Table 2-1}

**Table 2-1**

| No. | Reflectance (%) | | | Corrosion resistance | Reflectance (%) after sulfurization test | Heat releasing property (for reference) |
|---|---|---|---|---|---|---|
| | @400nm | @600nm | @800nm | R.N. | @600nm | |
| Ex. 1 | 85 | 97 | 98 | 9.2 | 82 | Good |
| Ex. 2 | 85 | 97 | 98 | 9.5 | 95 | Good |
| Ex. 3 | 84 | 94 | 97 | 9.6 | 91 | Good |
| Ex. 4 | 82 | 87 | 89 | 9.8 | 86 | Good |
| Ex. 5 | 81 | 85 | 87 | 9.8 | 85 | Good |
| Ex. 6 | 80 | 84 | 85 | 10 | 84 | Good |
| Ex. 7 | 85 | 97 | 98 | 9.2 | 96 | Good |
| Ex. 8 | 83 | 95 | 97 | 9.6 | 95 | Good |
| Ex. 9 | 82 | 88 | 89 | 9.8 | 88 | Good |
| Ex. 10 | 80 | 84 | 85 | 10 | 84 | Good |
| Ex. 11 | 82 | 94 | 96 | 9.7 | 91 | Good |
| Ex. 12 | 82 | 95 | 96 | 9.8 | 91 | Good |
| Ex. 13 | 82 | 94 | 97 | 9.8 | 92 | Good |
| Ex. 14 | 83 | 94 | 97 | 9.8 | 92 | Good |
| Ex. 15 | 82 | 93 | 96 | 9.8 | 92 | Good |
| Ex. 16 | 84 | 95 | 97 | 9.8 | 94 | Good |
| Ex. 17 | 83 | 96 | 97 | 9.8 | 95 | Good |
| Ex. 18 | 84 | 95 | 97 | 9.8 | 95 | Good |
| Ex. 19 | 80 | 85 | 95 | 9.8 | 96 | Good |
| Ex. 20 | 85 | 97 | 98 | 9.8 | 96 | Good |
| Ex. 21 | 85 | 97 | 98 | 9.8 | 95 | Good |
| Ex. 22 | 80 | 84 | 94 | 9.8 | 96 | Good |
| Ex. 23 | 85 | 97 | 98 | 9.8 | 95 | Good |
| Ex. 24 | 84 | 95 | 97 | 9.8 | 95 | Good |
| Ex. 25 | 85 | 97 | 98 | 9.8 | 96 | Good |
| Ex. 26 | 82 | 85 | 92 | 10 | 85 | Good |
| Ex. 27 | 82 | 84 | 91 | 10 | 91 | Good |
| Ex. 28 | 80 | 83 | 85 | 10 | 96 | Good |
| Ex. 29 | 81 | 84 | 87 | 10 | 84 | Good |
| Ex. 30 | 82 | 87 | 90 | 9.9 | 84 | Good |
| Ex. 31 | 82 | 87 | 91 | 9.9 | 85 | Good |
| Ex. 32 | 82 | 87 | 90 | 9.9 | 85 | Good |

{Table 2-2}

**Table 2-2**

| No. | Reflectance (%) | | | corrosion resistance | Reflectance (%) after sulfurization test | Heat releasing property (for reference) |
|---|---|---|---|---|---|---|
| | @400nm | @600nm | @800nm | R.N. | @600nm | |
| Ex. 33 | 82 | 85 | 87 | 10 | 85 | Good |
| Ex. 34 | 83 | 90 | 97 | 9.8 | 85 | Good |
| Ex. 35 | 84 | 96 | 98 | 9.8 | 95 | Good |
| Ex. 36 | 84 | 95 | 98 | 10 | 93 | Good |
| Ex. 37 | 84 | 96 | 98 | 10 | 95 | Good |
| Ex. 38 | 84 | 96 | 98 | 10 | 96 | Good |
| Ex. 39 | 85 | 97 | 98 | 9.8 | 97 | Good |
| Ex. 40 | 85 | 95 | 97 | 9.8 | 95 | Good |
| Ex. 41 | 84 | 96 | 98 | 9.8 | 96 | Good |
| Ex. 42 | 84 | 96 | 97 | 10 | 96 | Good |
| Ex. 43 | 85 | 95 | 97 | 10 | 95 | Good |
| Ex. 44 | 85 | 95 | 96 | 10 | 95 | Good |
| Ex. 45 | 84 | 93 | 96 | 9.8 | 91 | Poor |
| Ex. 46 | 85 | 93 | 96 | 9.8 | 91 | Poor |
| Ex. 47 | 86 | 95 | 96 | 9.8 | 94 | Poor |
| Ex. 48 | 85 | 97 | 98 | 9.8 | 97 | Poor |
| Conv. ex. 1 | 87 | 98 | 98 | 2 | 26 | Good |
| Comp. ex. 1 | 85 | 97 | 98 | 5 | 45 | Good |
| Comp. ex. 2 | 76 | 82 | 83 | 10 | 82 | Good |
| Comp. ex. 3 | 70 | 78 | 83 | 10 | 78 | Good |
| Comp. ex. 4 | 68 | 75 | 84 | 9.5 | 70 | Good |
| Comp. ex. 5 | 82 | 85 | 88 | 6.5 | 65 | Good |
| Comp. ex. 6 | 77 | 82 | 83 | 9.5 | 80 | Good |
| Comp. ex. 7 | 85 | 97 | 98 | 5 | 35 | Good |
| Comp. ex. 8 | 72 | 81 | 82 | 10 | 80 | Good |
| Comp. ex. 9 | 68 | 75 | 77 | 9.8 | 73 | Good |
| Comp. ex. 10 | 65 | 71 | 75 | 9.8 | 70 | Good |

Hereinafter, the description will be made on the thickness of each of the buffer layer and the remaining layer in the tables for the tested samples.
In Examples 4 to 6, 9, 10, and 33 to 38, and Comparative examples 2, 3, 6, and 8, by coating with the metal layer composed of the metal, such as indium, followed by subjecting to the heat treatment, the resultantly remained portion of the metal was diffused in the surface layer side of the silver layer, to form the buffer layer or the remaining layer. Thus, depending on the amount of the silver contained in the buffer layer or the remaining layer, the metal layer thickness ≠ (the metal oxide layer thickness + the buffer layer thickness + the remaining layer thickness). As the thickness of each of those layers, the thickness after the diffusion is shown in the tables.
In Examples 26 to 30 and Comparative example 4, the silver alloy layer was formed before coated with indium or tin, by subjected to the reflow treatment of the silver plating and the indium or tin plating provided thereon. The resultant silver alloy layer, which had been subjected to the reflow treatment in advance, was made of the silver alloy in which silver and other metal were uniformly diffused and the concentration distribution was uniform. From the definition of the buffer layer in the present invention, the resultant silver alloy layer was the buffer layer in the tables. Since the thickness of the metal layer as the outermost layer was thin, the entire layer became the oxide layer after the heating. The thickness thereof as shown in the tables was the thickness after the diffusion.
In Comparative example 5, the Ag-In alloy with thickness 1 µm was formed by the reflow treatment in advance, and the temperature was as high as 600°C. Thus, a portion of indium in the silver alloy layer was moved to the surface layer side, to concentrate. Then, the resultant concentrated portion was converted to a thin oxide layer, by subjecting to the heat treatment after the reflow treatment, but no sufficient corrosion resistance was obtained. Similarly to the above, the thickness as shown in the table was the thickness after the diffusion.
In Comparative example 6, indium was concentrated and remained in the surface layer, due to "no heat treatment". The buffer layer was formed by slightly diffusing into silver after the plating. The thickness of the thus-formed buffer layer was very thinner, as compared with other tested samples in which the heat treatment was performed. In Comparative example 6, the thickness as shown in the table, is not one after diffusion following the heat treatment, but one immediately after applying indium as the outermost layer.

As is apparent from those results, although the reflectance in the visible light region in each of Examples according to the present invention was slightly lower than Conventional example in some cases, it is understood that Examples each satisfied the reflectance required and were each extremely excellent in the stability after the corrosion resistance test. In particular, in Examples, it is also understood that the lead frame materials were obtained, each of which had almost little lowering in the reflectance after the sulfurization test and was excellent in the corrosion resistance, by forming the layer composed of silver or a silver alloy on copper, a copper alloy, aluminum or an aluminium alloy, and further providing the metal oxide layer as the upper layer thereof. Thus, it is apparent that when those lead frames in Examples are utilized for optical semiconductor devices, they would exhibit the extremely excellent reflectance property and long-term reliability. In addition, as for Examples 1 to 48, it is confirmed that the reflectance was 80% or more in the entire region of visible light wavelength 400 to 800 nm, which means that the reflectance was good.

### REFERENCE SIGNS LIST

- 1: Electrically-conductive substrate
- 2: Layer composed of silver or a silver alloy
- 3: Metal oxide layer
- 4: Optical semiconductor element
- 5: Buffer layer
- 6: Intermediate layer
- 7: Bonding wire

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2009-164132 filed in Japan on July 10, 2009, and Patent Application No. 2010-131605 filed in Japan on June 9, 2010, each of which is entirely herein incorporated by reference.

## Claims

1. A lead frame for an optical semiconductor device, comprising:
a layer composed of silver or a silver alloy formed on an electrically-conductive substrate;
a metal oxide layer of a metal other than silver as an outer layer of the layer composed of silver or a silver alloy,
wherein the metal oxide layer is colorless and transparent or silver gray in color, and has a thickness thereof from 0.001 to 0.2 µm.

2. The lead frame for an optical semiconductor device according to Claim 1, wherein the layer composed of silver or a silver alloy has a thickness from 0.2 to 5.0 µm.

3. The lead frame for an optical semiconductor device according to Claim 1 or 2, wherein the metal oxide layer is composed of an oxide containing at least one element selected from the group consisting of tin, indium, and antimony.

4. The lead frame for an optical semiconductor device according to any one of Claims 1 to 3, wherein the layer composed of a silver alloy contains 20 mass% or less in total of at least one element selected from the group consisting of tin, indium, and antimony.

5. The lead frame for an optical semiconductor device according to any one of Claims 1 to 3, wherein the layer composed of the silver alloy is comprised of the two layers of:
an outer layer which contains 20 mass% or less in total of at least one element selected from the group consisting of tin, indium, and antimony; and
an inner layer which contains less than 20 mass% in total of at least one element selected from the group consisting of tin, indium, and antimony.

6. The lead frame for an optical semiconductor device according to any one of Claims 1 to 5, wherein the electrically-conductive substrate is composed of a metal or alloy selected from the group consisting of copper, a copper alloy, aluminum, and an aluminum alloy.

7. The lead frame for an optical semiconductor device according to any one of Claims 1 to 6, further comprising:
at least one intermediate layer composed of a metal or alloy selected from the group consisting of nickel, a nickel alloy, cobalt, a cobalt alloy, copper, and a copper alloy, between the electrically-conductive substrate and the layer composed of silver or a silver alloy.

8. A method of producing the lead frame for an optical semiconductor device according to any one of Claims 1 to 7, comprising the steps of:
forming the layer composed of silver or a silver alloy on the electrically-conductive substrate;
forming a metal layer composed of a metal other than silver, on the outer surface of the layer composed of silver or a silver alloy; and
subjecting the metal layer to a heat treatment under an atmosphere of an oxygen concentration of 1,000 ppm or more, at a temperature from 100°C to a melting point of the metal other than silver, thereby to form the metal oxide layer composed of an oxide of the metal other than silver as the surface layer.

9. The method of producing the lead frame for an optical semiconductor device according to Claim 8, wherein the step of subjecting the metal layer to the heat treatment causes: formation of the metal oxide layer; and diffusion of a remaining metal, which is the metal of the metal layer and is not oxidized, into the layer composed of silver or a silver alloy, thereby to form a silver alloy layer composed of the remaining metal and silver.

10. The method of producing the lead frame for an optical semiconductor device according to Claim 8 or 9, wherein the thickness of the metal layer is from 0.001 to 0.3 µm.

11. The method of producing the lead frame for an optical semiconductor device according to any one of Claims 8 to 10, wherein the silver alloy layer composed of the remaining metal and silver contains 20 mass% or less in total of at least one element selected from the group consisting of tin, indium, and antimony.

12. The method of producing the lead frame for an optical semiconductor device according to any one of Claims 8 to 10, wherein the silver alloy layer composed of the remaining metal and silver is comprised of the two layers of:
a layer which contains 20 mass% or less in total of at least one element selected from the group consisting of tin, indium, and antimony; and
a layer which contains less than 20 mass% in total of at least one element selected from the group consisting of tin, indium, and antimony.

13. The method of producing the lead frame for an optical semiconductor device according to any one of Claims 8 to 12, wherein the silver alloy layer composed of the remaining metal and silver is formed, by subjecting a plating silver, and a plating of at least one element selected from the group consisting of tin, indium, and antimony, to a reflow treatment.

14. The method of producing the lead frame for an optical semiconductor device according to any one of Claims 8 to 13, wherein the layer composed of silver or a silver alloy is formed by plating.

15. The method of producing the lead frame for an optical semiconductor device according to any one of Claims 8 to 14, further comprising the step of:
forming an intermediate layer by plating, between the electrically-conductive substrate and the layer composed of silver or a silver alloy.

16. The method of producing the lead frame for an optical semiconductor device according to any one of Claims 8 to 15, wherein the step of forming the metal layer composed of the metal other than silver, is conducted by plating.

17. An optical semiconductor device, comprising:
the lead frame for an optical semiconductor device according to any one of Claims 1 to 7; and
an optical semiconductor element,
wherein the metal oxide layer is provided on a portion where at least the optical semiconductor element is mounted on the lead frame for an optical semiconductor device.
